# EUROPEAN PATENT SPECIFICATION

(11) **EP 3 499 525 B1**
(45) Date of publication and mention of the grant of the patent: **20.10.2021**
(21) Application number: 16912657.0
(22) Date of filing: 09.08.2016
(51) Int. Cl.: H01F 27/08, H05K 7/20

(54) **POWER SUPPLY DEVICE FOR OZONE GENERATOR, AND OZONE GENERATING DEVICE**
STROMVERSORGUNGSVORRICHTUNG FÜR OZONGENERATOR UND VORRICHTUNG ZUR ERZEUGUNG VON OZON
DISPOSITIF D'ALIMENTATION ÉLECTRIQUE DESTINÉ À UN OZONEUR ET DISPOSITIF GÉNÉRANT DE L'OZONE

(43) Date of publication of application: 19.06.2019
(73) Proprietor: Mitsubishi Electric Corporation, Chiyoda-ku Tokyo 100-8310 (JP)
(72) Inventor: TAKAUCHI, Daisuke, Tokyo 100-8310 (JP); ODAI, Yoshiaki, Tokyo 100-8310 (JP); NAKATANI, Hajime, Tokyo 100-8310 (JP); YOSHIDA, Toshihiro, Tokyo 100-8310 (JP); KUMAGAI, Takashi, Tokyo 100-8310 (JP); SHIMOHATA, Kenji, Tokyo 100-8310 (JP); ISHIZAKA, Satoru, Tokyo 100-8310 (JP); TAMIDA, Taichiro, Tokyo 100-8310 (JP)
(74) Representative: Witte, Weller & Partner Patentanwälte mbB
(86) International application number: PCT/JP2016/073400
(87) International publication number: WO 2018/029774

(56) References cited:
- EP-A1- 2 977 995
- JP-A- 2008 171 850
- JP-U- H0 226 310
- US-A- 3 784 838
- US-A1- 2010 118 488

## Description

### Technical Field

This invention relates to a power supply device for an ozone generator which generates ozone from gas containing oxygen by silent discharge.

### Background Art

In general, a power supply device for an ozone generator (ozonizer) has a large-capacity transformer, reactor and inverter, and further, high voltage is applied to the power supply device. Further, it is necessary to cool the above mentioned equipment, via a heat exchanger, housing, in which equipment of a power supply device is installed, is cooled. In Patent Document 1, it is disclosed such that in order to avoid deterioration of cooling efficiency due to increase of resistance in flow paths caused by condensation in a heat exchanger, by suppressing condensation at a part where resistance in flow paths is dominant, it is aimed to obtain housing which is excellent in cooling capacity.

In Patent Documents 2 and 3, it is disclosed such that by disposing a heat exchanger at a lower part of housing, while damage of internal parts is protected in a case where condensation occurs in a heat exchanger, internal equipment which generates heat is cooled. Further, in Patent Document 4, by disposing a heat exchanger being inclined at an acute angle to a bottom of casing in a casing, condensed water can be certainly discharged outside. Patent Document 5 discloses a method and apparatus for converting low frequency current to high frequency current and for applying the high frequency current to the electrodes of a corona generator. The frequency converter includes a rectifier circuit, and a chopping circuit. The chopping circuit includes an SCR and a firing circuit connected to the SCR. The chopping circuit does not require a conventional shut-off circuit. The SCR is connected to an ozone generator through a transformer and automatically shuts off. Patent Document 6 discloses a cold air flow path space in which cold air is caused to flow inside a housing, by an internal fan, disposed inside the housing. A magnetic component, mounted on the bottom portion of the housing is fixed by an attachment member, at a position that is in the cold air flow path space and faces a suction side, of the internal fan. Further, the flow of the cold air generated on the suction side of the internal fan passes inside the magnetic component. Patent Document 7 discloses a cabinet for a solar power inverter. A solar power inverter receives DC current from a solar panel and transforms the DC current into AC current. To cool the inverter equipment, an air inlet receives ambient air drawn into the cabinet by an air pressurizer. The ambient air is urged into a pressurized air plenum, from which two ports channel the air into at least two air paths to flow over the equipment in the cabinet. The equipment in the cabinet is arranged such that the air passes over more heat-sensitive equipment before reaching less heat-sensitive equipment. The equipment in the cabinet can be separated by grounded, metal walls to contain and diminish electromagnetic interference. The equipment may be accessed from a single, front side of the cabinet.

### Prior Art Document

### Patent Document

Patent Document 1 : JP H11-177267A
Patent Document 2 : JP2008-182233A
Patent Document 3 : JP2005-179102A
Patent Document 4 : JP H09-331607A
Patent Document 5 : US 3 784 838 A
Patent Document 6 : EP 2 977 995 A1
Patent Document 7 : US 2010/118488 A1

### Summary of the Invention

### Problems to be Solved by the Invention

Regarding conventional power supply devices for an ozone generator which applies more than 100kW of electric power, for example, a transformer, a reactor and an inverter are large and heavy, individually, therefore, in many cases, they are disposed in different housings. Further, their heat density is high, therefore, the configuration is designed such that designated wind tunnel is provided by using each heat exchanger and fan so as for cooling air to be sufficiently blown, and cooling is performed. Further, regarding the devices, high voltage is applied, therefore, while sufficient insulation distance is secured, from the point of safety, a partition plate for preventing electric shock is disposed, as a result, the size of the device is increased, and the configuration thereof is complicated. Consequently, the device have problems regarding disposition of devices which require maintenance, difficulties of operation and safety.

The present invention is made for solving the above mentioned problems, and aims to obtain a power supply device for an ozone generator having small size and simple configuration in which disposition of each device and cooling performance is optimized. Further, high voltage is applied to the power supply device for an ozone generator, therefore, the present invention aims to obtain a power supply device for an ozone generator having the configuration in which operation is easy to be performed during maintenance while insulation distance is secured and having excellent safety.

### Means for Solving Problems

According to the present invention, there is provided a power supply device for an ozone generator, which applies electric power to an ozone generator which generates ozone by silent discharge from gas containing oxygen, according to present invention comprises a transformer which transforms a voltage which is applied from a commercial AC power supply, an inverter which converts the AC voltage which is transformed by the transformer to be an AC voltage having higher frequency than a frequency of the commercial AC power supply and a reactor which is connected to an output of the inverter, wherein the transformer, the inverter and the reactor are disposed inside of one housing, a flat heat exchanger which cools passing air with cooling water is disposed at a lower part inside the housing, the transformer and the inverter are disposed above the heat exchanger, the reactor is disposed above the transformer and the inverter, a protection panel which isolates high voltage is disposed further toward a front side of the housing than the transformer and the inverter by being separated from a front door of the housing, and by a fan which is provided at a position inside the front door, cooling air is circulated by passing through an air passage which is a space between the front door and the protection panel, a space between the heat exchanger and a bottom of the housing, the heat exchanger, the transformer and the inverter, the reactor and the fan, sequentially.

### Effects of Invention

According to present invention, a transformer, a reactor and an inverter are disposed in the same housing, the space between a protection panel which isolates from a high voltage and a front door is made to be an air passage, a fan is disposed at a position which is inside of the front door, cooling air whose heat is exchanged by a heat exchanger is circulated in the housing, therefore a power supply device for an ozone generator in which operation for maintenance of fan is easy, whose size can be miniaturized can be obtained.

### Brief Description of Drawings

FIG.1 is a sectional side view showing the configuration of a power supply device for an ozone generator according to Embodiment 1 of present invention.
FIG.2 is an inside view showing the configuration of a power supply device for an ozone generator according to Embodiment 1 of present invention viewed from a front of the housing.
FIG.3 is an inside view showing the configuration of a power supply device for an ozone generator according to Embodiment 1 of present invention viewed from the top of the housing.
FIG.4 is an inside view showing the inside of the housing viewed from the top of an air passage partition plate showing the configuration of a power supply device for an ozone generator according to Embodiment 1 of present invention.
FIG.5 is a plan view showing the configuration of an air passage partition plate of a power supply device for an ozone generator according to Embodiment 1 of present invention.
FIG.6 is a top view showing the configuration of a heat exchanger of a power supply device for an ozone generator according to Embodiment 1 of present invention.
FIG.7 is a side view showing the configuration of a heat exchanger of a power supply device for an ozone generator according to Embodiment 1 of present invention.
FIG.8 is a sectional view showing a cooling air guide which is disposed at a lower part of a transformer of a power supply device for an ozone generator according to Embodiment 2 of present invention.
FIG.9 is a sectional view showing another cooling air guide which is disposed at a lower part of a transformer of a power supply device for an ozone generator according to Embodiment 2 of present invention.
FIG.10 is a sectional view showing another cooling air guide which is disposed at a lower part of a transformer of a power supply device for an ozone generator according to Embodiment 2 of present invention.
FIG.11 is a perspective view showing another cooling air guide which is disposed at a lower part of a transformer of a power supply device for an ozone generator according to Embodiment 2 of present invention.
FIG.12 is a sectional side view showing the configuration of a power supply device for an ozone generator according to Embodiment 3 of present invention.
FIG.13 is a block diagram showing the configuration of a power supply device for an ozone generator according to Embodiment 4 of present invention.

### Embodiments for Carrying Out the Invention

### Embodiment 1

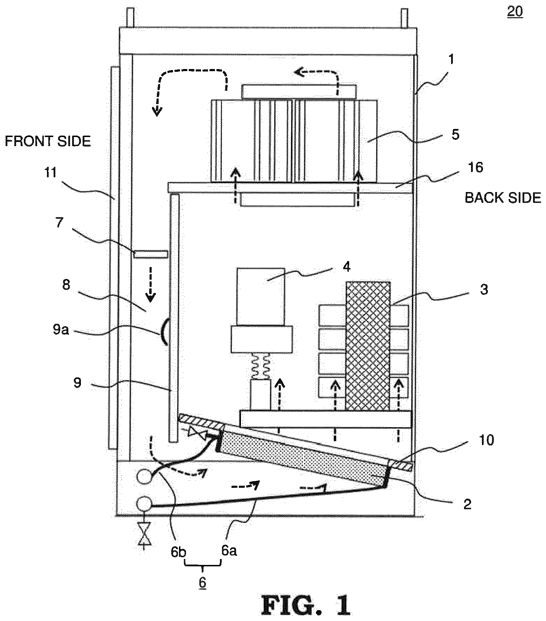

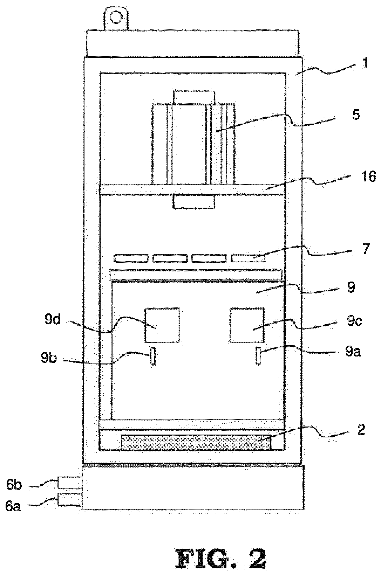

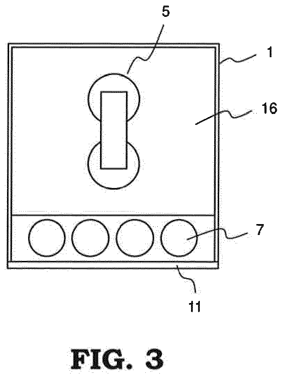

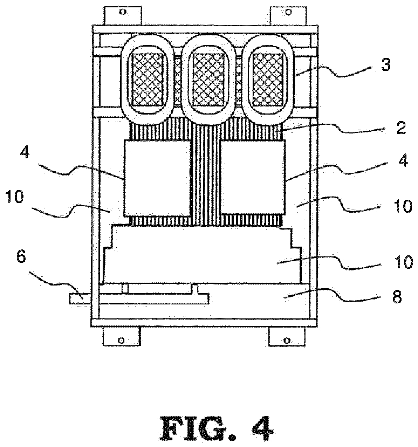

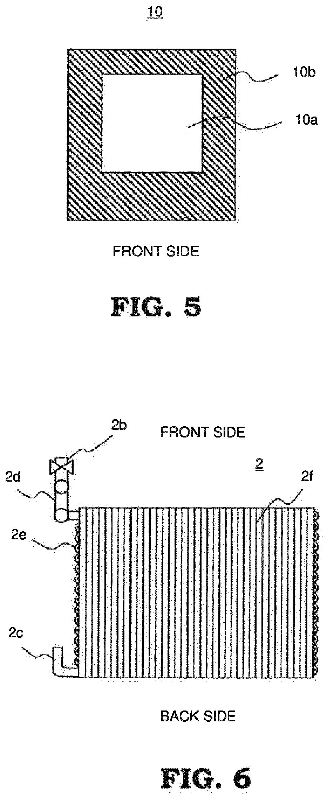

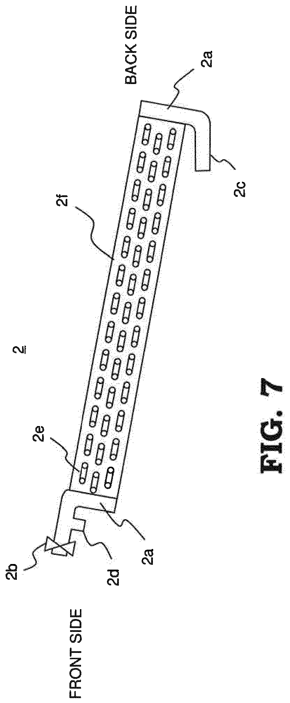

Hereinafter, a power supply device for an ozone generator according to Embodiment 1 will be described based on Figures 1 to 7. FIG.1 is a sectional side view showing one example of the configuration of a power supply device for an ozone generator 20 according to present invention, FIG.2 is an inside view in a case where being viewed from a front of the housing when a front door is opened, FIG.3 is an inside view being viewed from the top of the housing, FIG.4 is an inside view showing the inside of the housing being viewed from the top of an air passage partition plate, FIG.5 is a plan view showing the configuration of an air passage partition plate, FIG.6 is a top view showing the external form of a heat exchanger and FIG.7 is a side view showing the external form of a heat exchanger. As shown in Figs. 1 to 3, at a lower part of inside of the housing 1, a flat heat exchanger 2 which cools passing air with cooling water is disposed and an air passage partition plate 10 is disposed directly above the heat exchanger 2. A transformer 3 and an inverter 4 are disposed above the air passage partition plate 10 in a direction of depth of the housing, height of the housing 1 is lowered and above the housing 1, a reactor attaching plate 16 is provided so as to dispose a reactor 5. Further, at a side of front of inside of the housing 1, a fan 7 is provided and an air passage 8 is formed between a front door 11 and a protection panel 9. In Embodiment 1, the fan 7 is provided at a position which is inside of the front door 11 of the housing 1. Further, at a lower part of the housing 1, a cooling water pipe 6 which supplies cooling water to the heat exchanger 2 is provided. Further, in FIG.1, an arrow indicated with broken line shows air which is circulated inside the housing.

As shown in FIG.1, the heat exchanger 2 is disposed so as for flatly extending direction to be inclined with a down grade from a front side to a back side of the housing 1. It is preferable for an angle of inclination with horizon direction is an acute angle (smaller than 45 degrees), more preferable for an angle of inclination to be smaller than 25 degrees so as not for the space which is occupied by the heat exchange 2 to be large. According to the above mentioned disposition, it is configured such that in the space which is an air passage, between the heat exchanger 2 and a bottom of the housing, which is continued from the air passage 8 at the front of the housing 1, the space which is an air passage at an inlet side of the air passage 8 is made to be large and the space which is an air passage at an outlet side of the air passage is made to be narrow. According to the above mentioned, it is configured such that pressure loss in an air passage can be reduced and cooling air from the fan 7 can be flown easily even to the back of the housing 1 which is far from the air passage 8 at the front of the housing 1. Further, as shown in FIG.1 and FIG.4, so as for cooling air, which is introduced from the air passage 8 to a lower part of the housing 1, to be flown above the housing 1 via the heat exchanger 2, at directly above the heat exchanger 2, an air passage partition plate 10 which blocks the gap between the housing 1 and the heat exchanger 2 is provided. That is, as shown in FIG.5, the air passage partition plate 10 is configured such that so as for only air which passes through the heat exchanger 2 to be flown in an upper part, for a peripheral part 10b to be blocked to be an air passage shielding part and for a central part 10a to be vacant to be an air passage. Consequently, cooling air can only be flown to an upper part of the housing 1 via the heat exchanger 2, as a result, cooling of cooling air can be performed efficiently.

A heating value of the transformer 3 and the inverter 4 is large, and configuration of them is complicated, therefore, cooling is difficult. Further, the inverter 4 incorporates semiconductor switches, therefore, in order to prevent damaging of the semiconductors, it is necessary to decrease a temperature. Consequently, by disposing the transformer 3 and the inverter 4 directly above the heat exchanger 2, cooling can be performed with cooling air which is cooled most in the housing 1, and the maximum temperature of the transformer 3 and the inverter 4 can be suppressed. By disposing the transformer 3 at back of the housing 1 being away 5mm to 50mm, the back-side panel of the housing 1 can also be used as partition of an air passage, cooling air can be aggressively flown to inside or outside surface of the transformer 3. Regarding a distance between the back of the housing 1 and the transformer 3, by considering a voltage to be applied to the transformer 3, the back surface of the housing 1 should be away from the transformer 3 by an amount of necessary insulation distance at least. Further, by disposing the transformer 3 being away from the inverter 4 by 5 mm to 100 mm, the back side of the inverter 4 can also be used as an air passage, consequently cooling air can be aggressively flown to inside or outside surface of the transformer 3. However, regarding a distance between the transformer 3 and the inverter 4, by considering an electrical potential difference to be applied to the transformer 3 and the inverter 4, the transformer 3 should be away from the inverter 4 by an amount of necessary insulation distance at least. Further, by disposing the transformer 3 which is heavy at a lower part of the housing 1, the center of mass of the housing 1 is brought lower, consequently, from a view point of vibration during transport and earthquake-proof designs, it is advantageous.

A power supply device for an ozone generator according to the present invention is a power supply device for applying electric power to an ozone generator by silent discharge. Regarding an ozone generator by silent discharge, a load of a power supply is capacitive load, and generally, a reactor is provided at an output side of the power supply. The reactor 5 is attached on a reactor attaching plate 16 which is disposed above the transformer 3 and the inverter 4, and cooling is performed with cooling air after the transformer 3 and the inverter 4 are cooled. At a part which is a lower part of the reactor of the reactor attaching plate 16, an opening is formed so as for cooling air to flow. Though a temperature of cooling air which is flown to the reactor 5 increases, cooling can be performed by using all of cooling air which flows the housing 1, therefore the reactor can be sufficiently cooled. Further, in a case where the reactor 5 is sufficiently cooled, by making a size of the reactor attaching plate 16 small or by forming an opening at a part in addition to a part which is a lower part of the reactor, an amount of cooling air which is flown in the reactor 5 can be controlled. In this case, pressure loss of cooling air is decreased, therefore, the number of fan 7 can be decreased or a fan having lower capacity can be used, as a result, electric power and cost for cooling can be suppressed.

Here, an air-core coil reactor can be used as the reactor 5. In this case, an air-core part of the air-core coil is used as an air passage, therefore cooling of the reactor 5 can be efficiently performed. Further, by adapting an air-core coil reactor, weight is lowered, as a result, the configuration of housing can be simplified, from a view point of vibration during transport and earthquake-proof designs, the configuration can be advantageous.

The fan 7 is disposed at a position which is inside of a front door 11. The fan 7 is a part which requires maintenance, only by opening the front door 11, maintenance can be performed, consequently, operation efficiency during maintenance can be significantly increased. Conventionally, a fan is disposed at an upper part or a lower part or back of the housing, therefore, it is necessary to open a panel which is dedicated to maintenance or operation using a stepladder or operation which is performed by crouching may be necessary. By disposing the fan 7 at a position which is inside of the front door 11, workability can be significantly improved in comparison with that of conventional devices. Further, a protection panel 9 which is grounded is disposed between the fan 7 and the inverter 4 to which high voltage is applied, therefore, the configuration is safe, that is, the inverter 4 will not be touched by mistake when the fan 7 is replaced. Consequently, operator's emotional burden can be greatly reduced, as a result, more accurate and rapid operation can be performed. As above mentioned, special technique when a fan is replaced is not required, therefore, when malfunction occurs, user can replace fans rapidly by himself.

The air passage 8 is configured by the protection panel 9 for isolating the inverter 4 to which high voltage is applied and the front door 11 of the housing 1, and does not have a structural component which is dedicated to an air passage. By sharing structural components, miniaturization, simplification and reduction of cost of the housing 1 can be realized. Further, by providing the air passage 8 at a side of front of the housing 1, further as shown in FIG.2 and FIG.5, by providing the fan 7 at a side of front of the housing 1 at a left and right equally-position, cooling air can be circulated entire of the housing 1 without providing a structure such as a cooling air guide. Consequently, unevenness of temperature at a side of front of the housing 1 is reduced, therefore safety of a device for easing temperature increase is improved. Further, entire of the housing 1 becomes an air passage, therefore, a temperature of a surface of the housing becomes even, therefore, condensation is not generated, consequently, reliability is increased.

As shown in FIGs.1, 6 and 7, a cooling water pipe 6 is configured such that cooling water in the heat exchanger 2, which is disposed being inclined downward from a front side to a back side of the housing, is flown from a cooling water inlet 2c to a cooling water outlet 2d, that is, from bottom to top. Further, by providing an air vent valve 2b at the top, a cooling pile without air pocket can be configured, consequently, heat exchange capacity of a heat exchanger can be completely used up. Further, operation of water drain for preventing freezing cooling water when the device is not operated for a long period, for example, can be performed easily, as a result, maintenance performance can be improved.

As shown in a top view of FIG.6 and a side view of FIG.7, regarding the heat exchanger 2, it is configured such that plate-like fins 2f are inserted to a copper pipe 2e, heat is exchanged between cooling water which is flown in the copper pipe 2e and gas which passes through the fins 2f. The fins 2f are attached so as for surfaces of the fins to be parallel to up-and-down direction of the housing 1 and also to be parallel to a longitudinal direction of the housing 1 (a front to back direction). By attaching the fins with parallel to a longitudinal direction of the housing 1, cooling air can be passed through the entire surface of the heat exchanger 2 when cooling air passes through the heat exchanger 2. In a case where the attaching direction of the fins is perpendicular to the longitudinal direction of the housing 1, cooling air which is introduced to the heat exchanger 2 from back side of the housing 1 can not be spread to a front side of the heat exchanger 2, therefore, capacity of the heat exchanger 2 can not be sufficiently used up. Further, air flow of cooling air which is introduced to the heat exchanger 2 from back side of the housing 1 is more, therefore, in a case where the attaching direction of the fins is perpendicular to the longitudinal direction of the housing 1, pressure loss is increased. Consequently, air flow of entire of cooling air which flows the housing 1 is decreased, as a result, cooling capacity of the housing 1 is deteriorated.

As the heat exchanger 2 is disposed at a lower part of the housing 1, a cooling water pipe 6 for introducing cooling water to the heat exchanger 2 can be shorten in comparison with a case where the heat exchanger 2 is disposed at the center or an upper part of the housing 1, therefore, there is no waste of piping material, and a distance where cooling water flows is decreased, as a result, pressure loss can be decreased. Further, in a case where the heat exchanger 2 is disposed in the center or at an upper part of the housing 1, protection material such as a dedicated pan or a tray is necessary so as not for an electric part of the housing 1 to be gotten water due to water leak mainly from a copper pipe hair pin part or condensation. Inside the housing 1, high voltage equipment such as the transformer 3, the inverter 4, the reactor 5, etc. is disposed, therefore, between a protection material and high voltage equipment, insulation distance should be provided, as a result, a size of the housing 1 is made to be large. As the heat exchanger 2 is disposed at a lower part of the housing 1 and the air passage partition plate 10 is provided, therefore, even when water leaks from a hair pin part of the copper pipe 1 and water blows out, the air passage partition plate 10 functions to guard the transformer 3 and the inverter 4 to be prevented from being gotten water. Condensation of water drop trickles along the heat exchanger 2 which is disposed diagonally and drips from the lowest edge of the heat exchanger 2, therefore, there is no worry such that an electric part will be gotten water and malfunction of device will be occurred. Further, for water wet measures for electric parts, a dedicated approach is not intended, therefore, the number of part to be used is not increased, as a result, a device which is small-sized and simple and has reliable configuration can be realized.

Cooling water is flown in the copper pipe 2e of the heat exchanger 2, however, in many cases, pressure loss of cooling water becomes problems. When pressure loss of cooling water becomes large, it is necessary to increase pump capacity for flowing cooling water, therefore electric power to be used and cost is increased. It is configured such that the copper pipe 2e of the heat exchange 2 has headers 2a, in accordance with calorific value which is generated in the housing 1, the number of copper pipe 2e can be increased or decreased in parallel (in the configuration shown in FIG.7, three copper pipes 2e are disposed in parallel, however, the number of copper pipes can be decreased to two or increased to four, five or six), therefore, without losing pressure loss caused by copper pipes in the heat exchanger 2, operation of heat exchange can be performed. Further, by adjusting a length of the heat exchanger 2, that is, by adjusting a length of copper pipes, pressure loss can be adjusted to be arbitrary.

As shown in FIG.2, it is configured such that a protection panel 9 has windows for maintenance 9c and 9d, therefore, normal state or malfunction state of inverter unit can be easily checked without detaching the protection panel 9. As the protection panel 9 is not detached, operation can be simplified and the high pressure part is not exposed, therefore, the state can be safely checked. Further, it is configured such that handles 9a and 9b are provided, during the maintenance of the inverter unit, a plate can be easily detached, therefore, even when the number of staff for maintenance is one, a plate can be easily attached to and detached without dropping the protection panel 9.

As above mentioned, regarding a power supply device for an ozone generator according to Embodiment 1, a transformer, a reactor and an inverter are disposed in the same housing, the space between the protection panel 9 which isolates high voltage and the front door 11 is made to be an air passage, and a fan is provided at a position which is inside of a front door so as to circulate cooling air whose heat is exchanged by the heat exchanger in the housing. Consequently, a power supply device for an ozone generator in which maintenance operation of fan is easy and a size of the housing can be small-sized can be obtained.

### Embodiment 2

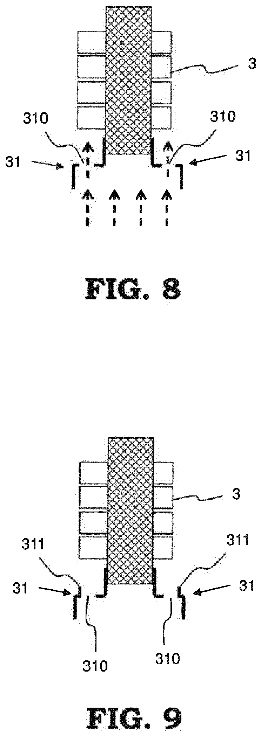

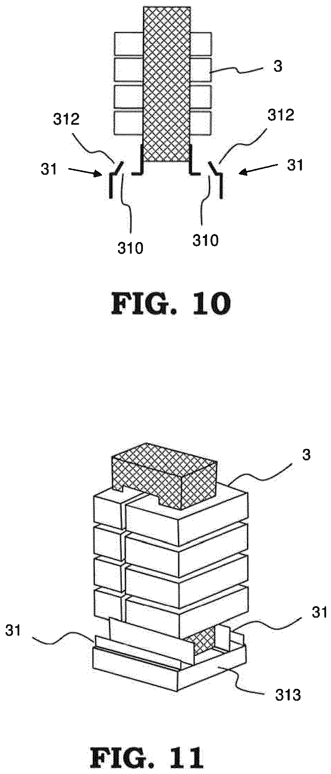

FIGs. 8 to 11 are sectional views showing the configuration of a cooling air guide 31 which is provided at a lower part of a transformer 3 of a power supply device for an ozone generator according to Embodiment 2 of present invention. FIG.8 shows the basic cooling air guide 31 which is configured such that cooling air is guided so as to be flown from an opening 310 to a transformer. Further, FIG.9 shows the cooling air guide 31 at which a guide plate 311 is provided perpendicularly to a side of a transformer of the opening 310. FIG.10 shows the cooling air guide 31 at which a guide plate is provided being inclined to a side of a transformer of the opening 310. Further, FIG.11 shows the configuration at which a guide plate 313 is provided also at a side of the cooling air guide 31 for taking in air which flows at left side and right side of the transformer 3.

In Embodiment 1, cooling configuration which is dedicated to the transformer 3 is not provided, however, the configuration of the transformer 3 is especially complicated, therefore, when cooling air is aggressively flown inside the transformer 3, the efficiency is more excellent in comparison with when cooling air is flown only outer surface. Consequently, in Embodiment 2, as shown in FIGs. 8 to 11, a cooling air guide 31 which aggressively cools the transformer 3 is provided at a lower part of the cooling air guide 31. A cooling air guide 31 shown in FIG.8 and a cooling air guide 31 shown in FIG.11 can be configured as single device, individually. A cooling air guide 31 shown in FIG.9 and a cooling air guide 31 shown in FIG.10 are configured by combining with FIG.8, individually. As above mentioned, by providing the cooling air guide 31, cooling air can be aggressively flown inside the transformer 3, therefore, cooling efficiency can be improved, as a result, the transformer 3 can be configured to be smaller sized. Further, the number of fan 7 can be decreased or a fan having lower capacity can be used, consequently, electric power required for cooling and cost can be suppressed.

### Embodiment 3

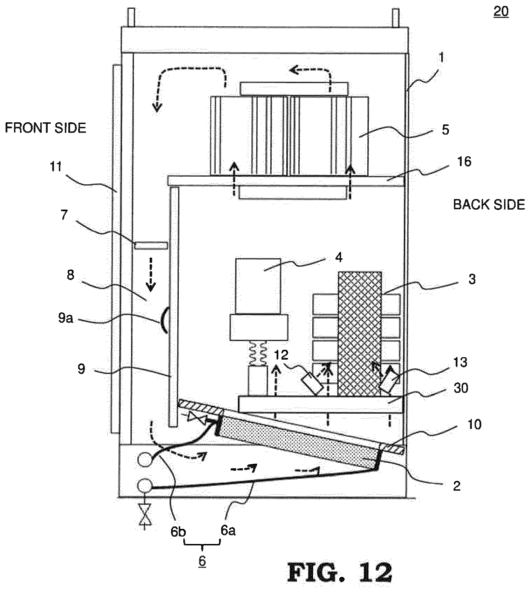

FIG.12 is a sectional side view showing the configuration of a power supply device for an ozone generator according to Embodiment 3 of present invention. In Embodiment 3, as shown in FIG.12, a fan 12 for cooling a transformer at front side and a fan 13 for cooling a transformer at back side are provided.

In Embodiment 3, a designated fan for cooling transformer which flows cooling air directly toward a transformer so as to forcibly cool the transformer 3 is provided in a power supply device for an ozone generator having the same configuration as that of a power supply device for an ozone generator in Embodiment 1, and the fans are disposed at a front side and a back side of the transformer 3. Regarding a fan, an axial flow fan, a line flow fan, etc. can be used, and if necessary, the fan12 for cooling a transformer at front side or the fan 13 for cooling a transformer at back side can be omitted, as a result, cooling capacity can be voluntarily adjusted.

### Embodiment 4

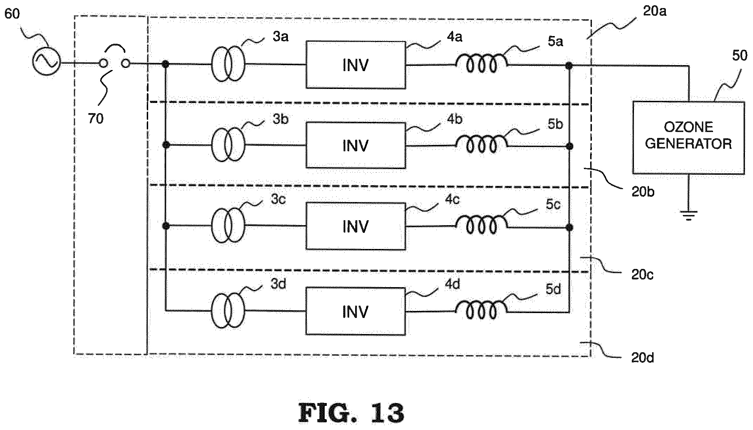

FIG.13 is a block diagram showing a configuration of a power supply device for an ozone generator according to Embodiment 4 of present invention. As a power supply for supplying electric power to an ozone generator 50 which generates ozone from gas containing oxygen by silent discharge, a power supply, in which a plurality of power supplies for ozone generators which are described in Embodiments 1 to 3 are connected in parallel, is used. Users require devices which generate various amount of ozone. Therefore, as a power supply device, power supply devices having various capacity should be provided. On the contrary, regarding an ozone generator according to Embodiment 4, any of ozone generator in Embodiment 1 to 3 having certain capacity, for example, 100kW is designated to be one unit, and by configuring such that, for example, 4 units of the above mentioned are connected in parallel so as to supply electric power to an ozone generator, a power supply for ozone generator having 400kW is configured. One example of the above mentioned is shown in a block diagram of FIG.13

A commercial AC power supply 60, via a switch 70, is connected to each of transformers 3a, 3b, 3c and 3d of each of power supply devices 20a, 20b, 20c and 20d for an ozone generator. Each of the transformer 3a, 3b, 3c and 3d transforms voltage from the commercial AC power supply. AC voltage which is transformed by the transformer is converted by inverters 4a, 4b, 4c and 4d to be AC voltage having frequency which is higher than that of the commercial AC power supply, the converted AC power voltage is outputted via reactors 5a, 5b, 5c and 5d and the outputted power is combined so as to supply electric power to the ozone generator 50. Consequently, the transformers 3a, 3b, 3c and 3d of each of the power supply devices 20a, 20b, 20c and 20d for an ozone generator has smaller electric power capacity than electric power which is supplied to whole of the ozone generator. It is needless to say such that other equipment of each of the power supply devices 20a, 20b, 20c and 20d for an ozone generator has smaller electric power than electric power which is supplied to whole of the ozone generator. The reactors 5a, 5b, 5c and 5d can be made to be reactors having a small value in comparison with a case in which one reactor is used for whole of the ozone generator without unifying in order to make appropriate value for unified electric power. Consequently, the above mentioned reactor having an air-core can be effectively used.

In FIG.13, by using 4 units of power supply device for an ozone generator having 100kw per one unit, a power supply device for an ozone generator is configured to supply electric power to an ozone generator having 400kW, however, in a case of an ozone generator having 200kW, it may be configured to have 2 units of power supply device for an ozone generator having 100kW per one unit. As above mentioned, when a power supply device for an ozone generator having certain capacity is designated to be one unit, as a power supply for supplying electric power to an ozone generator having capacity which is N times of capacity of one unit, N units of power supply device for an ozone generator may be connected. It is not necessary to design a power supply device for each of an ozone generator according to its capacity, therefore, designing a power supply can be simplified. A housing is configured to be independent, therefore, regarding each of a plurality of housings which are configured in parallel, a configuration, a connection, generating heat and cooling can be same. By making the above mentioned configuration, by designing housing having certain capacity and evaluating, making the capacity to be large volume such as N times of the certain capacity can be easily performed. Further, a reactor is connected to output side of a power supply device for ozone generator of each unit, flowing of electric current from other unit is suppressed, therefore, a plurality of power supply devices for ozone generators can be easily connected.

As above mentioned, in a power supply device for an ozone generator of one unit in an ozone generator according to Embodiment 4, power capacity of equipment including a transformer is smaller than electric power which is supplied to whole of the ozone generator, and by using the power supply device alone, electric power for whole of the ozone generator can not be sufficiently supplied. By using an appropriate number of the power supply devices for an ozone generator in accordance with the electric capacity of the ozone generator so as to configure a power supply for an ozone generator to supply the electric power to whole of the ozone generator, it is not necessary to dispose equipment of power supply device, perform connecting, cooling designing per capacity of ozone generator, therefore, time and cost for spending for designing and verifying can be reduced.

Further, cooling air in a unit is circulated from front side to a lower part, back side and front side, therefore when a plurality of units are connected in parallel, even by taking away partition walls between adjacent units, flow of cooling air will not be affected. Consequently, partition walls between adjacent units can be taken away, therefore price of device can be reduced.

Further, present invention may be made without departing from the scope thereof, by combining embodiments, appropriately changing or omitting.

### Description of Reference Signs

1. housing
2. heat exchanger
2e copper pipe
2f fin
3, 3a to 3d transformer
4, 4a to 4d inverter
5, 5a to 5d reactor
7 fan
8 air passage
9 protection panel
10 air passage partition plate
11 front door
12, 13 fan for cooling a transformer
20, 20a to 20d, power supply device for an ozone generator
31 cooling air guide
50 ozone generator
60 commercial alternative power supply

## Claims

1. A power supply device for an ozone generator, which applies electric power to an ozone generator which generates ozone by silent discharge from gas containing oxygen, comprising
a transformer (3) which transforms a voltage which is applied from a commercial AC power supply,
an inverter (4) which converts an AC voltage which is transformed by the transformer (3) to be an AC voltage having higher frequency than a frequency of the commercial AC power supply
and a reactor (5) which is connected to an output of the inverter (4),
wherein the transformer (3), the inverter (4) and the reactor (5) are disposed inside of one housing (1),
a flat heat exchanger (2) which cools passing air with cooling water is disposed at a lower part inside the housing (1),
the transformer (3) and the inverter (4) are disposed above the heat exchanger (2),
the reactor (5) is disposed above the transformer (3) and the inverter (4),
a protection panel (9) which isolates high voltage is disposed further toward a front side of the housing (1) than the transformer (3) and the inverter (4) by being separated from a front door (11) of the housing (1),
and, by a fan (7) which is provided at a position inside the front door (11), cooling air is circulated by passing through an air passage (8) which is a space between the front door (11) and the protection panel (9), a space between the heat exchanger (2) and a bottom of the housing (1), the heat exchanger (2), the transformer (3) and the inverter (4), the reactor (5) and the fan (7), sequentially.

2. The power supply device for an ozone generator according to claim 1, wherein the heat exchanger (2) is disposed being inclined with a down grade from the front side to a back side of the housing (1), the space between the heat exchanger (2) and a bottom of the housing (1) is narrowed from the front side to the back side of the housing (1).

3. The power supply device for an ozone generator according to claim 1 or claim 2, wherein the heat exchanger (2) is configured by inserting plate-shaped fins (2f) to a copper pipe (2e) so as to perform heat exchanging between cooling water which is flown in the copper pipe (2e) and gas which passes through the plate-shaped fins (2f), and the plate-shaped fins (2f) are provided so as for surfaces of the plate-shaped fins (2f) to be parallel to an up-and-down direction of the housing (1) and to be parallel to a longitudinal direction of the housing (1).

4. The power supply device for an ozone generator according to any one of claims 1 to 3, wherein the reactor is an air-core coil reactor (5) and an air-core part is configured so as for the cooling air to pass through.

5. The power supply device for an ozone generator according to any of claims 1 to 4, wherein a cooling air guide (31) which guides the cooling air to the transformer (3) is disposed at a lower part of the transformer (3).

6. The power supply device for an ozone generator according to any one of claims 1 to 5, wherein a fan (7) for cooling a transformer which blows directly cooling air toward the transformer (3) is disposed.

7. An ozone generating device comprising a plurality of power supply devices claimed by any one of claims 1 to 6 and an ozone generator (50), wherein all outputs of each of the power supply devices are connected so as to supply electric power to an ozone generator (50).

## Patentansprüche

1. Leistungszufuhreinrichtung für einen Ozongenerator, der elektrische Leistung auf einen Ozongenerator beaufschlagt, der Ozon durch Glimmentladung aus Sauerstoff enthaltendem Gas erzeugt, mit
einem Transformator (3), der eine Spannung transformiert, die von einer kommerziellen AC-Leistungszufuhr beaufschlagt ist,
einem Wechselrichter (4), der eine AC-Spannung, die durch den Transformator (3) transformiert ist, dazu transformiert, eine AC-Spannung zu sein, die eine höhere Frequenz aufweist als eine Frequenz der kommerziellen AC-Leistungszufuhr,
und einer Spule (5), die mit einem Ausgang des Wechselrichters (4) verbunden ist,
wobei der Transformator (3), der Wechselrichter (4) und die Spule (5) innerhalb eines Gehäuses (1) angeordnet sind,
einem flachen Wärmetauscher (2), der vorbeiströmende Luft mit Kühlwasser kühlt, ist an einem unteren Teil innerhalb des Gehäuses (1) angeordnet,
der Transformator (3) und der Wechselrichter (4) sind oberhalb des Wärmetauschers (2) angeordnet,
die Spule (5) ist oberhalb des Transformator (3) und des Wechselrichters (4) angeordnet,
einem Schutzpanel (9), das Hochspannung isoliert, ist weiter in Richtung einer Vorderseite des Gehäuses (9) als der Transformator (3) und der Wechselrichter (4) angeordnet, indem es von einer Vordertür (11) des Gehäuses (1) separiert ist,
und, mittels eines Gebläses (7), das an einer Position innerhalb der Vordertür (11) bereitgestellt ist, wird Kühlluft zirkuliert, indem sie durch einen Luftdurchtritt (8) tritt, der ein Zwischenraum zwischen der Vordertür (11) und dem Schutzpanel (9) ist, ein Zwischenraum zwischen dem Wärmetauscher (2) und einem Boden des Gehäuses (1), dem Wärmetauscher (2), dem Transformator (3) und dem Wechselrichter (4), der Spule (5) und dem Gebläse (7), nacheinander, ist.

2. Leistungszufuhreinrichtung für einen Ozongenerator nach Anspruch 1, wobei der Wärmetauscher (2) geneigt angeordnet ist mit einem Gefälle von der Vorderseite zu einer Rückseite des Gehäuses (1), wobei der Zwischenraum zwischen dem Wärmetauscher (2) und dem Boden des Gehäuses (1) sich von der Vorderseite zu der Rückseite des Gehäuses (1) verschmälert.

3. Leistungszufuhreinrichtung für einen Ozongenerator nach Anspruch 1 oder Anspruch 2, wobei der Wärmetauscher (2) konfiguriert ist durch Einfügen von plattenförmigen Lamellen (2f) zu einem Kupferrohr (2e), um Wärmetauschen zwischen Kühlwasser, das in dem Kupferrohr (2e) strömt, und Gas, das durch die plattenförmigen Lamellen (2f) tritt, durchzuführen, und die plattenförmigen Lamellen (2f) sind dazu bereitgestellt, dass Oberflächen der plattenförmigen Lamellen (2f) parallel zu einer Oben-Unten-Richtung des Gehäuses (1) sind und parallel zu einer Longitudinalrichtung des Gehäuses (1) sind.

4. Leistungszufuhreinrichtung für einen Ozongenerator nach einem der Ansprüche 1 bis 3, wobei die Spule eine Luftkernspulen-Spule (5) ist und ein Luftkernteil dazu konfiguriert ist, dass die Kühlluft durch diesen hindurchtritt.

5. Leistungszufuhreinrichtung für einen Ozongenerator nach einem der Ansprüche 1 bis 4, wobei eine Kühlluftführung (31), die die Kühlluft zu dem Transformator (3) führt, einem unteren Teil des Transformators (3) angeordnet ist.

6. Leistungszufuhreinrichtung für einen Ozongenerator nach einem der Ansprüche 1 bis 5, wobei ein Gebläse (7) zum Kühlen eines Transformators angeordnet ist, das direkt Kühlluft in Richtung des Transformators (3) bläst.

7. Ozongeneratoreinrichtung mit einer Mehrzahl von Leistungszufuhreinrichtungen beansprucht durch einen der Ansprüche 1 bis 6 und einem Ozongenerator (50), wobei alle Ausgänge von jeder der Leistungszufuhreinrichtungen verbunden sind, um elektrische Leistung zu einem Ozongenerator (50) zuzuführen.

## Revendications

1. Dispositif d'alimentation électrique pour un ozoneur, appliquant de l'énergie électrique à un ozoneur qui produit de l'ozone par décharge silencieuse à partir d'un gaz renfermant de l'oxygène, comprenant
un transformateur (3) transformant une tension appliquée à partir d'une alimentation électrique en courant alternatif commerciale,
un onduleur (4) convertissant une tension alternative transformée par le transformateur (3) en une tension alternative de fréquence plus élevée qu'une fréquence de l'alimentation électrique en courant alternatif commerciale,
et une réactance (5) connectée à une sortie de l'onduleur (4),
le transformateur (3), l'onduleur (4) et la réactance (5) étant agencés à l'intérieur d'un boîtier (1),
un échangeur de chaleur plat (2) refroidissant l'air qui passe par de l'eau de refroidissement étant agencé au niveau d'une partie inférieure à l'intérieur du boîtier (1),
le transformateur (3) et l'onduleur (4) étant agencés au-dessus de l'échangeur de chaleur (2),
la réactance (5) étant agencée au-dessus du transformateur (3) et de l'onduleur (4),
un panneau de protection (9) isolant des hautes tensions étant agencé plus près d'une face avant du boîtier (9) que du transformateur (3) et de l'onduleur (4) en étant espacé d'une trappe avant (11) du boîtier (1),
et, au moyen d'un ventilateur (7) positionné en dedans de la trappe avant (11), de l'air de refroidissement étant mis en circulation en passant à travers un passage d'air (8) constituant un espace entre la trappe avant (11) et le panneau de protection (9), un espace entre l'échangeur de chaleur (2) et un fond du boîtier (1), l'échangeur de chaleur (2), le transformateur (3) et l'onduleur (4), la réactance (5) et le ventilateur (7), séquentiellement.

2. Dispositif d'alimentation électrique pour un ozoneur selon la revendication 1, dans lequel l'échangeur de chaleur (2) est agencé incliné selon une pente descendante depuis la face avant jusqu'à une face arrière du boîtier (1), l'espace entre l'échangeur de chaleur (2) et un fond du boîtier (1) se rétrécissant depuis la face avant jusqu'à la face arrière du boîtier (1).

3. Dispositif d'alimentation électrique pour un ozoneur selon la revendication 1 ou la revendication 2, dans lequel l'échangeur de chaleur (2) est configuré par insertion d'ailettes en forme de lame (2f) dans un conduit en cuivre (2e) de manière à permettre un échange de chaleur entre de l'eau de refroidissement amenée à circuler dans le conduit en cuivre (2e) et du gaz passant à travers les ailettes en forme de lame (2f), et les ailettes en forme de lame (2f) sont placées de sorte que des surfaces des ailettes en forme de lame (2f) soient parallèles à une direction haut/bas du boîtier (1) et soient parallèles à une direction longitudinale du boîtier (1).

4. Dispositif d'alimentation électrique pour un ozoneur selon l'une quelconque des revendications 1 à 3, dans lequel la réactance est une réactance à bobine à noyau d'air (5) et une partie formant noyau d'air est configurée pour être traversée par l'air de refroidissement.

5. Dispositif d'alimentation électrique pour un ozoneur selon l'une quelconque des revendications 1 à 4, dans lequel un guide d'air de refroidissement (31) guidant l'air de refroidissement jusqu'au transformateur (3) est agencé au niveau d'une partie inférieure du transformateur (3).

6. Dispositif d'alimentation électrique pour un ozoneur selon l'une quelconque des revendications 1 à 5, dans lequel un ventilateur (7) destiné à refroidir un transformateur est agencé pour souffler de l'air de refroidissement directement vers le transformateur (3).

7. Dispositif de génération d'ozone, comprenant une pluralité de dispositifs d'alimentation électrique revendiqués par l'une quelconque des revendications 1 à 6 et un ozoneur (50), toutes les sorties de chacun des dispositifs d'alimentation électrique étant connectées de manière à alimenter un ozoneur (50) en énergie électrique.
